Europäisches Patentamt

(19) European Patent Office

Office européen des brevets

(11) Publication number: **0 361 602**
**A2**

## (12) EUROPEAN PATENT APPLICATION

(21) Application number: **89202387.0**

(22) Date of filing: **22.09.89**

(51) Int. Cl.⁵: **H01L 33/00 , G02F 1/37 , H01S 3/19**

(30) Priority: **28.09.88 GB 8822806**

(43) Date of publication of application:
**04.04.90 Bulletin 90/14**

(84) Designated Contracting States:
**DE FR GB IT NL**

(71) Applicant: **PHILIPS ELECTRONIC AND ASSOCIATED INDUSTRIES LIMITED**
**Philips House 188 Tottenham Court Road**
**London W1P 9LE(GB)**

(84) **GB**

Applicant: **N.V. Philips' Gloeilampenfabrieken**
**Groenewoudseweg 1**
**NL-5621 BA Eindhoven(NL)**

(84) **DE FR IT NL**

(72) Inventor: **Dobson, Peter James**
**CHY-YN-MENETH**
**112 Mount Park Avenue**
**South Croydon CR2 6DJ(GB)**

(74) Representative: **Clark, Jane Anne et al**
**PHILIPS ELECTRONICS Patents and Trade Marks Department Philips House 188**
**Tottenham Court Road**
**London W1P 9LE(GB)**

(54) **A light emitting device.**

(57) A light emitting device has an active layer (1) for generating light of a given wavelength ($\lambda_1$) in response to an external stimulus, and first and second cladding layers (2 and 3) bounding the active layer (1) for defining the active layer (1) as a waveguide for guiding light of the given wavelength ($\lambda_1$) along the active layer (1) to be emitted at an end face (1a) of the active layer. The active layer (1) and/or at least one of the cladding layers (3) is formed of an optically non-linear medium for causing light at half the given wavelength to be generated with light of the given wavelength, at least one cladding layer (3) having a periodic grating structure (4) having a period

$$\Lambda = \frac{m\lambda_2}{n}$$

(where $\lambda_2$ is half the given wavelength, m is the order of diffraction and n is the refractive index of the said one cladding layer) for phase-matching with light of half the given wavelength and being formed so as to be substantially transparent to light of half the given wavelength so as to enable light of half the given wavelength to emerge via the periodic grating (4) normally of the active layer (1).

*Fig.1.*

# A LIGHT EMITTING DEVICE

This invention relates to a light emitting device comprising an active layer for generating light for a given wavelength in response to an external stimulus, and first and second cladding layers bounding the active layer for defining the active layer as a waveguide for guiding light of the given wavelength along the active layer to be emitted at an end face of the active layer, the active layer and/or at least one cladding layer comprising an optically non-linear medium for causing light at half the given wavelength to be generated with light of the given wavelength.

Such a device is described in a paper entitled "second harmonic generation in an AlGaAs Double-Heterostructure Laser" by Nagaatsu Ogasawara et al published in the Japanese Journal of Applied Physics Vol. 26 No. 8 August, 1987 at pages 1386 to 1387.

It is an aim of the present invention to provide a light-emitting device which enables frequency-doubled light, that is light of half the given wavelength, to be emitted from the device as a well directed beam emerging normally of the active layer.

According to the present invention, there is provided a light emitting device comprising an active layer for generating light of a given wavelength in response to an external stimulus, and first and second cladding layers bounding the active layer for defining the active layer as a waveguide for guiding light of the given wavelength along the active layer to be emitted at an end face of the active layer, the active layer and/or at least one cladding layer comprising an optically non-linear medium for causing light at half the given wavelength to be generated with light of the given wavelength, characterised in that the said at least one cladding layer has a periodic grating structure having a period

$$\Lambda = \frac{m\lambda 2}{n}$$ (where $\lambda_2$ is half the given wavelength, m is the order of diffraction and n is the refractive index of the said one cladding layer) for phase-matching with light of half the given wavelength and is formed so as to be substantially transparent to light of half the given wavelength so as to enable light of half the given wavelength to emerge via the periodic grating normally of the active layer.

It should be understood that, as used herein, the term light means electromagnetic radiation of a wavelength lying within the range of the spectrum extending from the near infrared to the near ultraviolet.

The present invention thus provides a light emitting device which comprises an active layer for generating light of a given wavelength and which provides the means for extracting light of half the given wavelength from the device normally of the active layer. The extraction of light of half the given wavelength is achieved by exploiting a non-linear optical medium in either or both the active region and a cladding region and by providing a built-in periodic structure phase matched for the light of half the given wavelength.

Thus, a device embodying the invention enables frequency-doubled light, that is light of half the given wavelength, to be coupled out of the device to provide a well directed beam emerging normally of the active layer. In addition light of the given wavelength may also be emitted but from an end face of the active layer so that two approximately perpendicular beams can be provided, one being of twice the frequency of the other.

In a preferred embodiment, the said one cladding layer has a free surface defining alternate crests and troughs and the said one cladding layer is sufficiently thin at the troughs to be substantially transparent to light of half the given wavelength. In this case, the two cladding layers may be formed of the same material.

The active layer and the other of the cladding layer may be formed of III-V semiconductor material. The active layer may simply form a double heterostructure with the cladding layers or may be more complex. Thus, for example, the active layer could comprise one or more quantum well or superlattice active regions and may have a separate confinement region. Alternately, the said one cladding layer may be formed of a material, for example zinc sulphide, transparent to the frequency-doubled light. Where the said one cladding layer is formed of a material transparent to the frequency-doubled light, then the periodic grating may be provided on the free surface of the said one cladding layer or at the interface with the active layer.

The structure of a device embodying the invention has the advantage of enabling the frequency-doubled light which would otherwise be strongly absorbed by the III-V semiconductor material to be emitted from the device.

Embodiments of the invention will now be described, by way of example, with reference to the accompanying drawings, in which:

Figure 1 is a schematic cross-sectional view illustrating the basic structure of a light-emitting device in accordance with the invention;

Figure 2 shows an Ewald sphere construction illustrating the principle underlying the invention;

Figure 3 shows a further Ewald sphere construction illustrating the application of higher order diffraction conditions;

Figure 4 is a schematic perspective view of a first embodiment of a light emitting device in accordance with the invention;

Figure 5 is a schematic cross-sectional view of a second embodiment of a light emitting device in accordance with the invention;

Figure 6 is a schematic cross-sectional view of a third embodiment of a light emitting device in accordance with the invention; and

Figure 7 is a schematic cross-sectional view of a fourth embodiment of a light emitting device in accordance with the invention.

It should be understood that the Figures are merely schematic and are not drawn to scale. In particular certain dimensions such as the thickness of layers or regions may have been exaggerated whilst other dimensions may have been reduced. It should also be understood that the same reference numerals are used throughout the Figures to indicate the same or similar parts.

Referring now to the drawings, a light emitting device comprises an active layer 1 for generating light of a given wavelength $\lambda_1$ in response to an external stimulus, and first and second cladding layers 2 and 3 bounding the active layer 1 for defining the active layer as a waveguide for guiding light of the given wavelength $\lambda_1$ along the active layer 1 to be emitted at an end face 1a of the active layer 1. In accordance with the invention the active layer 1 and/or at least one cladding layer 3 comprises an optically non-linear medium for causing light at half the given wavelength (that is light of wavelength $\lambda_2 = \frac{\lambda_1}{2}$ to be generated with light of the given wavelength $\lambda_1$, the said at least one cladding layer 3 having a periodic grating structure 4 having a period

$$\Lambda = \frac{m\lambda_2}{n}$$ (where $\lambda_2$ is half the given wavelength, m is the order of diffraction and n is the refractive index of the said one cladding layer) for phase-matching with light of wavelength $\lambda_2$ and is formed so as to be substantially transparent to light of half the given wavelength to enable light of wavelength $\lambda_2$ to emerge via the periodic grating 4 normally of the active layer 1.

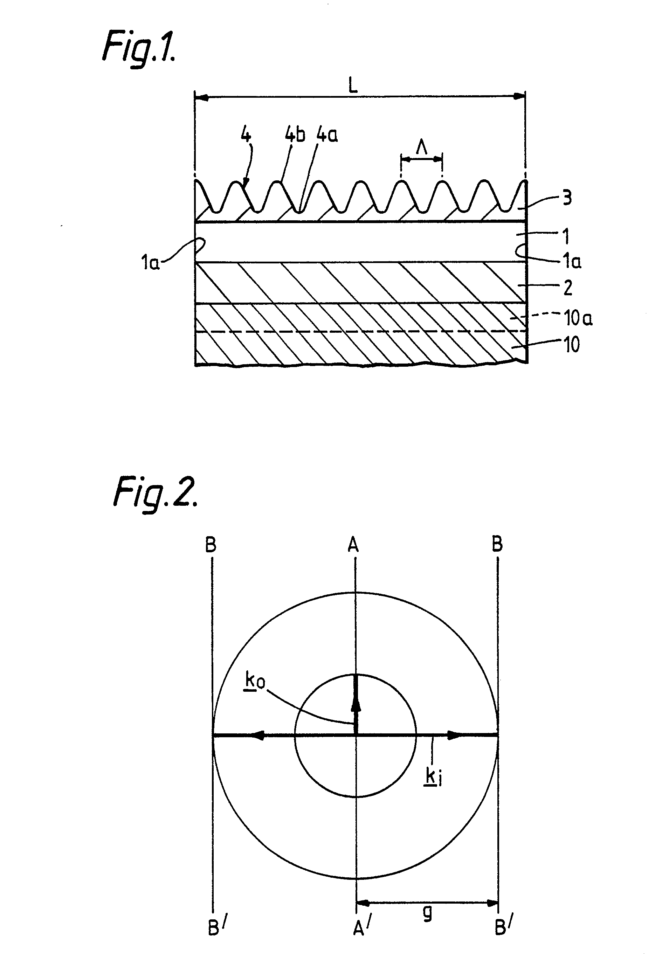

Referring now specifically to Figure 1, there is shown a schematic cross-sectional view of a light emitting device in accordance with the invention, in particular a laser diode.

As shown in Figure 1, the device comprises a monocrystalline gallium arsenide substrate 10 highly doped with n + conductivity type impurities, for example silicon, onto which the cladding layers 2 and 3 and active layer 1 are formed using a conventinal epitaxial growth technique such as molecular beam epitaxy (MBE), metal organic vapor phase epitaxy, (MOVPE) or a metal organic MBE (MOMBE). As is conventional in the art, as indicated by the dotted line in Figure 1, a buffer epitaxial layer 10a of highly n conductivity type gallium arsenide may be grown on the substrate 10 prior to growth of the cladding layers 2 and 3 and the intervening active layer 1.

In this example, the first cladding layer 2 is formed as an n conductivity type layer of an aluminium gallium arsenide $Al_xGa_{1-x}As$ alloy with, typically, x = 0.3 and with, typically, a dopant concentration of 5 x $10^{18}$ atoms $cm^{-3}$. After formation of the first cladding layer 2, the active layer 1 is formed. In this example, the active layer 1 is formed as a not-intentionally doped layer of gallium arsenide. After formation of the active layer 1, the second cladding layer 3 is formed, in this example, as a layer of p conductivity type aluminium gallium arsenside of the same composition as the first cladding layer 2.

The structure thus described forms a double heterostructure. The active layer 1 may have a thickness in the range of from about 200 to about 400 nm (namometres) whilst the cladding layers 2 and 3 may be 1.5micrometres thick.

As an alternative to forming the active layer 1 as a simple gallium arsenide layer, the active region 1 may be formed as a quantum well region with one or more gallium arsenide quantum well active regions separated by, for example, aluminium gallium arsenide alloy barrier layers or AlAs/GaAs superlattice barrier layers to provide a separate confinement quantum well type laser structure. The structure of the active layer 1 is not important to the present invention and any suitable conventional structure may be adopted.

After formation of the second cladding layer 3, the periodic grating 4 is formed by an appropriate conventional technique, for example by electron beam lithography or optical holography and etching. As mentioned above, the periodic grating 4 is formed so as to have a period of

$$\Lambda = \frac{m\lambda_2}{n}$$ and is so deeply etched that either the cladding layer material is completely removed in the troughs 4a between the peaks 4b of the grating 4 or so that the remaining thickness of the second cladding layer 3 beneath the grating troughs 4a is sufficiently small so as not to cause any appreciable absorption of frequency doubled light, that is light of wavelength $\lambda_2 = \frac{\lambda_1}{2}$ so that the second cladding layer 3 is substantially transparent to light of half the given wavelength in so far as it enables light to wavelength $\lambda_2$ to be emitted normally of the active layer 1 via the second cladding layer 3. Typically, the thickness of the second cladding layer 3 remaining beneath the troughs 4a may lie in the range of from about 10 to about 20 nanometres.

After growth of the cladding layers 2 and 3 and active layer 1 and definition of the grating, the structure is cleaved, as is known in the art, so as to define a number of laser diode structures of which only one is shown in Figure 1. The cleaved end faces 1a and 1b form the mirrored end faces of the laser cavity defined by the active layer 1. Although not necessary, the cleaved end faces 1a and 1b may be further treated, for example coated with multiple film dielectric layers, to improve reflection properties.

As will be described in greater detail below, the laser diode shown in Figure 1 may be an electrically pumped laser diode in which case, as will be discussed below, electrical contacts (not shown in Figure 1) have to be provided on the cladding layers 2 and 3 to enable a voltage to be applied across the device to provide the external stimulation necessary for laser generation. Alternatively, the laser diode may be optically pumped although this is more unusual for semiconductor lasers. Where optical pumping is to be used, then the first and second cladding layers 2 and 3 need not necessarily be of opposite conductivity types.

The principles underlying the invention will now be discussed with reference to Figure 2 which shows an Ewald or reflecting sphere construction for the grating 4.

In the periodic grating 4 of period $\wedge$ the frequency doubled light of wavelength $\lambda_2$ is diffracted as shown in Figure 2, such that one set of beams is parallel to the surface and one set is normal to the surface. The wave vectors of the beams inside the grating 4 are given by

$|k_i| = \frac{2\pi n}{\lambda_2}$ where n is the effective refractive index of the medium or material forming the periodic grating 4 and the wavevector outside, that is in air, is $|k_0| = \frac{2\pi}{\lambda_2}$. The grating period $\wedge$ gives a grating wavevector of $|g| = \frac{2\pi}{\wedge}$. The lines $AA'$ $BB'$ in Figure 2 represent the reciprocal lattice of the grating and these have a "width" which is the inverse of the lateral dimension of the grating structure, i.e. width = $\frac{2\pi}{L}$, where L is the total length of the periodic grating 4.

Hence the angular divergence of the beam of frequency-doubled light emitted from the grating 4 will be

$$\frac{2\pi}{Lk_0} = \frac{\lambda_2}{L}.$$

In order to achieve the above-described diffraction conditions then $(g) = |k_i|$ so that

$$\frac{2\pi}{\wedge} = \frac{2\pi n}{\lambda_2} \quad \text{or} \quad \wedge = \frac{\lambda_2}{n}$$

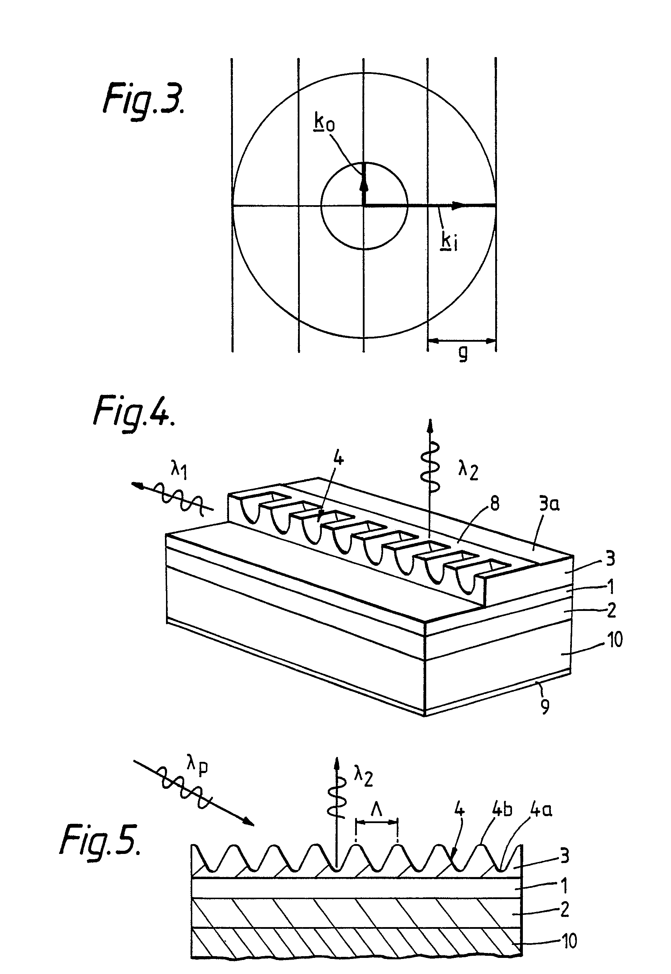

In the example being described where $\lambda_1$ = 0.8$\mu$m and where the material of the second cladding layer 3 is an aluminium gallium arsenide alloy having the composition $Al_{0.6}Ga_{0.4}As$ so that the effective refractive index of the second cladding layer 3 is 4.6, then the period $\wedge$ of the grating should be 0.087 micrometres. Although gratings of such small dimensions can be manufactured using current electron beam lithography techniques, as illustrated in Figure 3, manufacturing difficulties may be alleviated by designing the grating 4 for a high order diffraction condition so that

$$g = \frac{k_i}{m} \quad \text{and} \quad \wedge = \frac{m\lambda_2}{n},$$

where m is the diffraction order. In this case, then for the second order diffraction condition the grating period $\wedge$, for the same values of refractive index n and alloy composition given above, should be 0.174$\mu$m and for the third order diffraction condition $\wedge$ = 0.261$\mu$m.

As described above, the laser diode may be electrically or optically pumped. Figure 4 is a schematic perspective view of a laser diode structure adapted for electrical pumping or stimulation of laser light generation.

The laser diode structure shown in Figure 4 is fabricated in the same manner as the structure shown in Figure 1 and described above with the exception that prior to defining the periodic grating 4, an electrically conductive contact or electrode layer 8 is deposited onto the surface 3a of the second cladding layer 3. The electrically conductive contact layer 8 may be formed of any suitable electrically conductive material but is preferably formed of a metal or metal alloy having, at the frequency 2$\omega$ of the frequency doubled light, a real component dielectric constant $E_1$ equal to but of opposite sign to the material of the second cladding layer 3. This criterion will ensure that radiative interface plasmon modes will exist between the metal and semiconductor and the metal will be an effective "antenna" for emission. Where the second cladding layer 3 is formed as described above of an aluminium gallium arsenide alloy of composition $Al_{0.4}Ga_{0.6}As$ which has $E_1 \approx 18$ at 443nm alloys of aluminium and magnesium which have their composition adjusted to give $E_1 \approx -18$ at 443 nm will be suitable materials for the electrically conductive contact layer 8.

A further electrically conductive contact layer 9 is deposited onto the back face of the substrate 10 as is conventional in the art to enable a voltage to be applied across the device to stimulate electrically generation of laser light as is conventional for current injection semiconductor diode lasers. In operation, the device shown in Figure 4 will, as explained above with reference to Figure 1, generate in the active region 1 light at the given wavelength $\lambda_1$ related to the band gap Eg of the gallium arsenide active layer 1 which light will be guided by the waveguide defined by the cladding layers 2 and 3 along the active layer 1 to be emitted to an end face 1a of the laser device. In addition, because of the non-centro-symmetric nature of the III-V semiconductor material forming the active layer 1 frequency-doubled light at wavelength $\lambda_2$ will be generated and phase-matched by the periodic grating 4 to cause light of wavelength $\lambda_2$ to be emitted normally of the active layer 1 via the periodic grating 4.

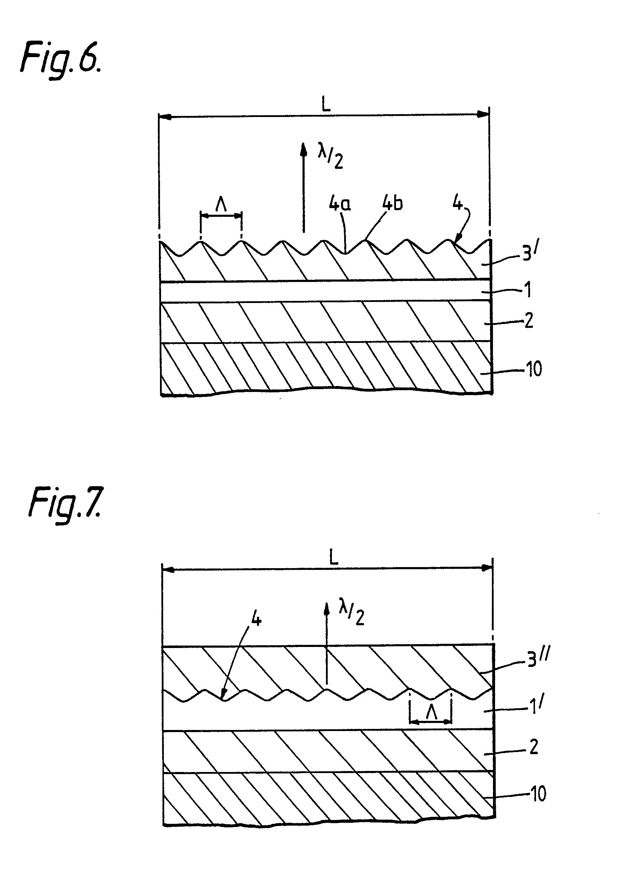

Figure 5 is a cross-sectional view of a laser diode embodying the invention which is optically, rather than electrically, pumped by means of a pump laser light beam of wavelength $\lambda_p$ directed into the active layer 1 via the periodic grating 1. The wavelength $\lambda_p$ of the pump beam is of course selected to cause the device to lase at the wavelength $\lambda_1$ and the pump beam may be provided by a diode laser or any other similar suitable conventional device. The device shown in Figure 5 differs from that shown in Figure 4 in that, of course, there is no necessity for electrical contacts. In addition, in this example, the periodic grating may be a two-dimensional grating 4, that is a grating which has the period $\Lambda$ in a direction perpendicular to the plane of Figure 5 in addition to that shown. The use of a two dimensional grating should assist in coupling more frequency-doubled light out of the device.

As an alternative to using the same material for the first and second cladding layers 2 and 3, a material which is transparent to the frequency-doubled light may be used for the second cladding layer 3 provided the material chosen still provides suitable confinement and waveguiding for light at the fundamental wavelength $\lambda_1$ of the laser device. Figure 6 is a cross-sectional view of an optically pumped laser diode in accordance with the invention where the second cladding layer 3′ is formed from such a material, for example p conductivity type (zinc sulphide or any suitable wide band gap Eg > 2.8ev (electron volts)) n conductivity for the materials and wavelengths given above. In this case, it is not necessary that the thickness of the second cladding layer 3′ beneath the troughs 4a of the grating be kept small and accordingly the grating 4 may be formed merely at the surface 3a of the second cladding layer 3′. As an alternative, as shown in Figure 7, the grating 4 may be formed at the interface 11 between the active layer 1′ and the second cladding layer 3″.

The light emitting device need not necessarily be a laser diode but could merely be a light emitting diode in which case the cleaved end faces would not be needed.

A device embodying the invention thus enables use to be made of the frequency-doubled light which is generated in non-centrosymmetric semiconductor materials such as III-V semiconductor materials by avoiding the strong absorption of the frequency-doubled light which would otherwise occur and also provides a phase-matching condition to ensure that the frequency-doubled light emerges as a well directed beam via the diffraction grating 4 normally of the active layer 1.

From reading the present disclosure, other modifications will be apparent to persons skilled in the art. Such modifications may involve other features which are already known in the art and which may be used instead of or in addition to features already described herein. Although claims have been formulated in this application to particular combinations of features, it should be understood that the scope of the disclosure of the present invention also includes any novel feature or any novel combination of features disclosed herein either explicitly or implicitly, whether or not it relates to the same invention as presently claimed in any claim and whether or not it mitigates any or all of the same technical problems as does the present invention. The applicants hereby give notice that new claims may be formulated to such features and/or combination of such features during the prosecution of the present application or of any further application derived therefrom.

## Claims

1. A light emitting device comprising an active layer for generating light of a given wavelength in response to an external stimulus, and first and second cladding layers bounding the active layer for defining the active layer as a waveguide for guiding light of the given wavelength along the active layer to be emitted at an end face of the active layer, the active layer and/or at least one cladding layer comprising an optically non-linear medium for causing light at half the given wavelength to be generated with light of the given wavelength, characterised in that the said at least one cladding layer has a periodic grating structure having a period

$$\Lambda = \frac{m\lambda_2}{n}$$ (where $\lambda_2$ is half the given wavelength, m is the order of diffraction and n is the refractive index of the said one cladding layer) for phase-matching with light of half the given wavelength and is formed so as to be substantially transparent to light of half the given wavelength so as to enable light of half the given wavelength to emerge via the periodic grating normally of the active layer.

2. A device according to Claim 1, further characterised in that the said one cladding layer has a free surface defining alternate crests and troughs and the said one cladding layer is sufficiently thin at the troughs to be substantially transparent to light of half the given wavelength.

3. A device according to Claim 2, further characterised in that the two cladding layers are formed of the same material.

4. A device according to Claim 1, further characterised in that the said one cladding layer is formed of a material transparent to light of half the given wavelength and the periodic grating is formed at the interface between the said one cladding layer and the active layer.

5. A device according to Claim 1, 2, 3 or 4, further characterised in that the active layer and the other cladding layer comprise III-V semiconductor material.

6. A device according to Claim 4, further characterised in that the active layer and the other cladding layer comprise III-V semiconductor material whilst the said one cladding layer comprises II-VI semiconductor material.

7. A device according to Claim 6, further characterised in that the II-VI semiconductor material comprises zinc sulphide.

8. a device according to Claim 5, 6 or 7, further characterised in that the active layer comprises gallium arsenide and the other cladding layer comprises aluminium gallium arsenide.

9. A device according to any one of the preceding claims, further characterised in that the first and second cladding layers are semiconductor layers doped with impurities of opposite conductivity type and electrically conductive contacts are provided on the first and second cladding layers for enabling a voltage to be applied across the device to provide the external stimulus.

10. A device according to Claim 9, further characterised in that the electrically conductive contact provided on the said one cladding layer is such that, at half the given wavelength, the real part of the dielectric constant of the said one cladding layer is of equal magnitude but opposite sign to that of the said one cladding layer.

## Fig.1.

## Fig.2.

Fig.3.

Fig.4.

Fig.5.

## Fig.6.

## Fig.7.